# EUROPEAN PATENT SPECIFICATION

(11) **EP 1 911 085 B1**
(45) Date of publication and mention of the grant of the patent: **12.10.2011**
(21) Application number: 06809161.0
(22) Date of filing: 06.07.2006
(51) Int. Cl.: H01L 21/762

(54) **METHOD OF PRODUCTION OF A FILM**
VERFAHREN ZUR HERSTELLUNG EINES FILMS
PROCEDE SERVANT A PRODUIRE UNE COUCHE

(30) Priority: 08.07.2005 FR 0507300; 06.09.2005 US 221045
(43) Date of publication of application: 16.04.2008
(73) Proprietor: S.O.I.Tec Silicon on Insulator Technologies, 38190 Bernin (FR)
(72) Inventor: AULNETTE, Cécile, F-38000 Grenoble (FR); CAYREFOURCQ, Ian, F-38330 Saint Nazaire les Eymes (FR); MAZURE, Carlos, F-38190 Bernin (FR)
(74) Representative: Bomer, Françoise Marie
(86) International application number: PCT/IB2006/003071
(87) International publication number: WO 2007/017763

(56) References cited:
- WO-A-2005/038903
- WO-A-2005/053018
- FR-A- 2 852 445
- US-A1- 2003 008 478

## Description

### BACKGROUND OF THE INVENTION

The present invention relates to the production of a film, starting from an initial wafer, including a step of implanting atomic species through one of its faces in order to form within a buried implanted zone at a determined depth, the film to be produced then being bounded by the implanted face of the wafer and by this implanted zone.

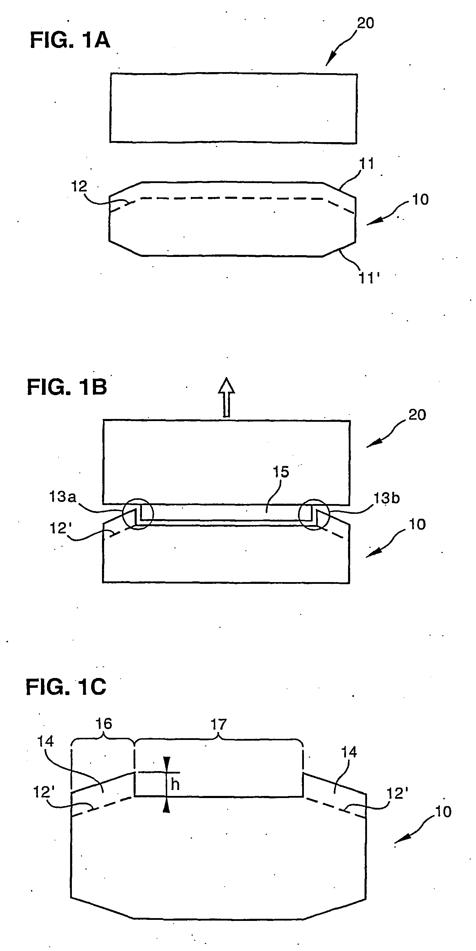

This technique is especially employed for lifting off said film, by carrying out, after said implantation, the following steps (illustrated by figures 1A and 1B):
- the wafer 10 is bonded on its implanted face to a receiving substrate 20; and
- energy (typically thermal and/or mechanical energy) is supplied so as to detach the film 15 from the implanted zone 12 (this step is also known by the term Smart-Cut^{®}).

The film 15 is then taken off from the wafer 10, to be transferred onto the receiving substrate 20 (see figure 1 B).

Referring to figures 1A and 1B, the faces of the wafer 10 are usually chamfered on the periphery (chamfers 11 and 11'), so that the bonding of the receiving substrate 20 to the wafer 10 takes place mainly only on the surface of the wafer 10 that is not located on the chamfer 11.

Thus, referring to figures 1B and 1C, the film 15 is not exactly taken off from the entire surface of the wafer 10, since, after taking-off, the chamfered portion of the film initially bounded by the implanted zone remains attached to the wafer 10, thus forming a ring 14 that surrounds a hollow volume corresponding approximately to the volume of the film 15 taken off.

In the particular case in which the film 15 is made of crystalline material, strains (starting from the zones 13a and 13b) can then propagate throughout the film 15 and thus have major deleterious consequences.

Furthermore, the receiving substrate 20 may itself have a peripheral chamfer, not necessarily identical to the chamfer 11 of the wafer 10, which may therefore be offset relative to the chamfer 11 so that there is irregular detachment of the film 15 along the edges.

The latter effect is also accentuated by the fact that the bonding forces at the bonding interface are of course weaker along the edges than in the central portion.

The film 15 taken off therefore has rather irregular edges and internal defects or damage.

### DESCRIPTION OF THE PRIOR ART

The technique proposed in documents US 2004/0121557 and WO 2005/038903 for solving this taking-off problem is illustrated in figures 2A to 2C. It consists, prior to taking-off, in routing the wafer 10 so as to remove the peripheral chamfered zones and in forming in their stead a step in the thickness of the wafer 10 with a height h.

This height h may therefore be chosen to be greater than the implant depth h1 formed in the wafer 10 for the purpose of taking-off. The implanted zone 12 is therefore separated from the bottom of the step 11, and therefore from the peripheral zone of the wafer 10, by a distance equal to (h - h1). The film 15 bounded by the implanted zone 12 and the implanted face therefore no longer includes chamfered peripheral zones, its free face then consisting solely of a plane surface suitable for good bonding to the receiving substrate 20.

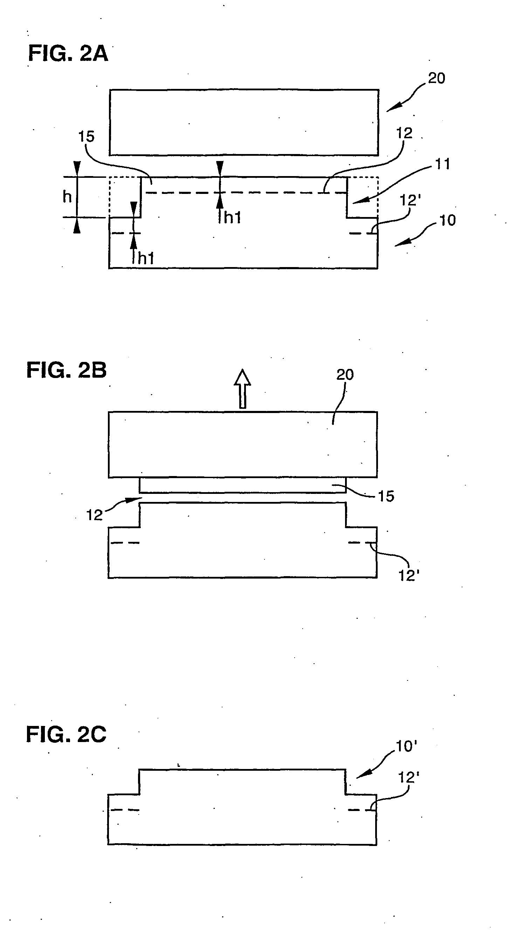

Referring to figure 2B, this entire film 15 is then taken off, without having said fracture problems along the edges.

The film 15 taken off is thus of better quality.

The receiving substrate 20 and the film 15 may however be contaminated by the wafer 10 around its peripheral portions (i.e. on the step 11). This is because the step 11 has also undergone implantation and therefore includes an implanted zone 12' that weakens the superjacent portion. Furthermore, particles may become detached from this fragile portion when the implanted zone 12' is subjected to external stresses, such as in a heat treatment carried out in order to detach the film 15, and these particles then contaminate the film 15 and the receiving substrate 20.

This particle contamination problem may also be manifested during the "reclaiming" treatments needed to reform a clean film, which will again be taken off.

This contamination may be worse if the same wafer 10 is used for several successive taking-off operations, the same step 11 then undergoing an alternation of implantations and heat treatments.

It might therefore be proposed, on the basis of document US 6 596 610, to subject the wafer 10' (as shown in figure 2C) after taking-off to a thermal and/or mechanical and/or chemical reclaiming treatment in order to help in the removal of the remaining implanted zones 12, so as to be able to reuse the wafer 10'.

However, the reclaiming operation proposed by US 6 596 610 remains complex and expensive as it requires a selective treatment of the ring, and this treatment must also be repeated at each taking-off.

The present invention proposes to solve these problems.

### SUMMARY OF THE INVENTION

One objective of the invention is thus to take off a film from a wafer in such a way that the film is of good crystalline quality and has regular borders, with minimal contamination.

Another objective is to find a means for reclaiming the wafer that has provided the film, so that it can again provide other films with minimum risk of contamination.

According to a first aspect, the invention proposes a method of producing a film intended for applications in electronics, optics or optronics starting from an initial wafer, which includes a step of implanting atomic species through one of the faces of the initial wafer, which method comprises the following stages:
(a) formation of a step of determined height around the periphery of the wafer, the mean thickness of the wafer at the step being less than the mean thickness of the rest of the wafer;
(b) protection of said step against the implantion of atomic species; and
(c) implantation of atomic species through that face of the wafer having said step, so as to form an implanted zone at a determined implant depth, said film being determined, on one side, by the implanted face of the wafer and, on the other side, by the implanted zone.

Other features of this method of producing a film are the following:
- stage (a) includes the bonding of a film to a substrate in order to form said initial wafer, the film having a smaller area than the substrate so that, once these have been bonded, said step is at least partly determined by the difference in area between the film and the substrate;
- stage (a) includes the removal of material from a peripheral surface of the wafer down to a determined removal depth so as to form said step;
- stage (a) furthermore includes a thickening of the step;
- the implant depth is equal to the height of the step or less;
- according to a first embodiment of the invention, stage (b) includes the formation of a protective layer extending over at least said step and an operation to remove those portions of the protective layer which are not located on the step is optionally carried out by anisotropic etching or by polishing;
- according to a second embodiment of the invention, stage (b) displays during stage (c), by masking the step during the implantation;
- stage (c) is carried out in such a way that the implanted zone is a zone of weakness, in which the method furthermore includes the following stages:
- a receiving substrate is bonded to the implanted face of the wafer; and then
- energy is supplied so as to detach the film from the wafer in the zone of weakness;
- the method furthermore includes, one or more times, the following successive stages:
- implantation of atomic species through the detachment surface of the previous film so as to form a zone of weakness that defines a new film below the detachment surface; and
- bonding of a receiving substrate to the implanted face of the wafer.

According to a second aspect, the invention proposes a wafer for providing a film intended for applications in electronics, optics or optronics, which includes a peripheral zone having a smaller mean thickness than the rest of the wafer by about 1 micron or more, so as to form a step around the periphery of the wafer, wherein the step is coated with a protective layer in order to protect the step from being implanted with atomic species and wherein the wafer has a buried implanted zone.

Other features of this wafer are:
- the protective layer is made of amorphous material;
- the protective layer comprises silicon oxide, silicon nitride, PSG or BPSG;
- according to a first embodiment, the wafer is made of bulk crystalline material;
- according to a second embodiment, the wafer is a composite structure consisting mainly of crystalline materials;
- the wafer comprises a support substrate, a buffer structure and an upper layer sufficiently thick to be able to detach therefrom a film by Smart-Cut^{®}, the upper layer optionally comprising Si₁₋ₓGeₓ and Si_{1-y}Ge_{y}, with x differing from y, x and y being between 0 and 1, respectively;
- the height of the step is equal to or greater than the thickness of the upper layer.

### BRIEF DESCRIPTION OF THE DRAWINGS

Other features, objects and advantages of the invention will become more clearly apparent from the description below, illustrated by the following figures:
Figures 1A to 1C show various stages of a first known method for lifting off a film;
Figures 2A to 2C show various stages of a second known method of lifting off a film;
Figures 3A to 3F show various stages of a method of lifting off a film according to the invention;
Figures 4A and 4B show two stages in the formation of a protective layer according to the invention;
Figure 5 is a graph showing the distribution of implantation energy over the thickness of implanted material;
Figure 6 shows a first wafer that can undergo several successive film taking-off operations according to the invention;
Figure 7 shows a second wafer that can undergo several successive film taking-off operations according to the invention.

### DESCRIPTION OF THE PREFERRED EMBODIMENTS

The preferred method according to the invention is a film taking-off method using the Smart-Cut^{®} and wafer bonding techniques.

The invention relates in particular to the preparation of the donor wafer, intended for the taking-off operation that will be carried out subsequently, implementing the following stages:
(a) the wafer is routed so as to form a step around the periphery of the wafer, the mean thickness of the wafer on the step being less than the mean thickness of the rest of the wafer;
(b) a protective layer is formed on the step so as to protect the latter from being implanted with atomic species; and
(c) atomic species are implanted through that face of the wafer which has been routed, so as to form therein a buried zone of weakness.

Advantageously, these stages are implemented so that the height of the step is greater than the depth of implantation.

Thus, the peripheral zone of the wafer will not impair the quality of the subsequent taking-off when a receiving substrate will be bonded onto the implanted face of the wafer and then the bonds in the implanted zone will be broken.

Moreover, the presence of the protective layer guarantees that the peripheral portions of the wafer are protected against the implantation of atomic species during stage (c), thus making subsequent reclaiming easier and/or improving the quality of the subsequent taking-off operation(s).

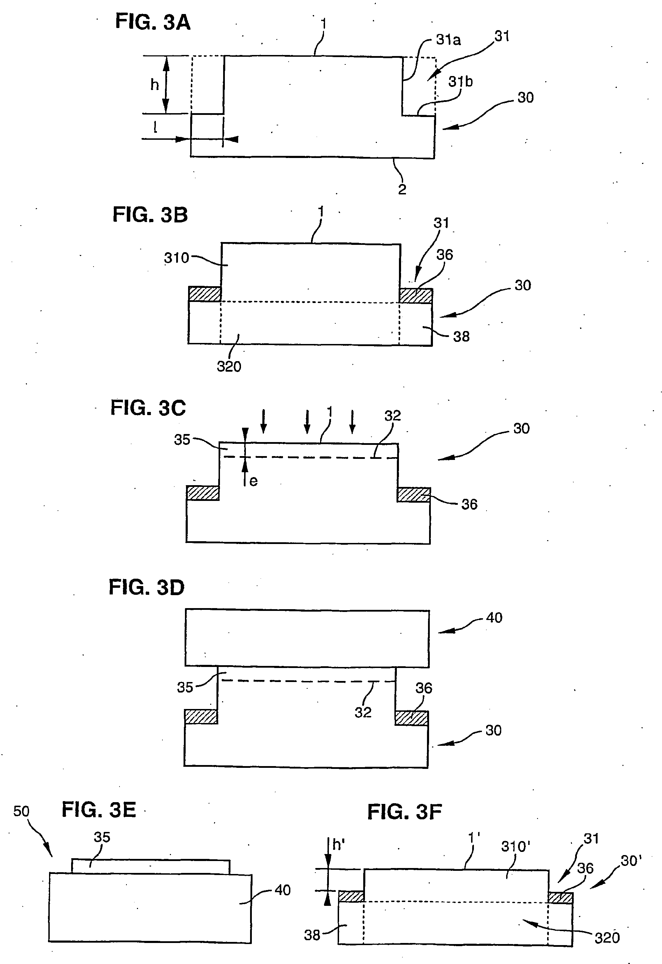

Figures 3A to 3F show the various stages of a method according to the invention for lifting off a film from an initial wafer 30.

This wafer 30 mainly, and advantageously, consists of one or more crystalline materials, such as semiconductor materials.

The wafer 30 is made of bulk material or is a composite structure consisting of a succession of layers.

According to a first embodiment, the wafer 30 includes a chamfered peripheral zone (as discussed above). Given that such a wafer 30 typically has a circular shape, this chamfered peripheral zone has an annular shape around the periphery of the wafer 30. According to this first embodiment, the wafer 30 is a fresh wafer, that is to say it has not yet undergone film taking-off according to the invention.

According to a second embodiment, the wafer 30 includes a chamfered peripheral zone and has undergone at least one thin-film taking-off operation consistent with that discussed above and illustrated by figures 1A and 1B. According to this second embodiment, the wafer 30 therefore includes a peripheral ring 14 that surrounds a hollow volume approximately identical to the volume of the previously lifted-off film.

According to a third embodiment of the invention, the wafer 30 has undergone beforehand a taking-off operation according to the invention and has thus already been routed according to the invention. Thus, the initial wafer 30 already includes a peripheral step.

According to a fourth embodiment of the invention, the wafer 30 consists of a hybrid substrate formed from a support substrate, onto which a film has been transferred during a prior operation. The wafer 30 consists of an SOI (Silicon On Insulator) wafer for example, or else an SSOI (Strained Silicon On Insulator) or SiGeOI (SiGe On Insulator) wafer. Since in this case the wafer 30 has been produced by film transfer, a step already exists around the periphery of this wafer, corresponding to the nontransferred ring zone during the transfer operation. However, this "step" may not be sufficient, and it is necessary to carry out a routing operation on this type of substrate too. The reader may refer to document EP 1 519 409 for further details regarding this type of wafer 30 and the way in which it is produced.

Referring to figure 3A, the routing of the wafer 30 is carried out over a width I and a depth h.

The routing is carried out in such a way that the step 31 thus formed consists of a vertical wall 31 a lying essentially perpendicular to the front face 1 of the wafer 30 and a horizontal wall 31 b optionally lying parallel to the front face 1 of the wafer 30, these two walls 31 a and 31 b intersecting each other.

The width I of the step 31 is advantageously chosen to be equal to or greater than the width of the peripheral zone of the wafer 30 in one of the above four embodiments (that is to say the chamfer according to embodiment 1, the ring according to embodiment 2 and the step according to embodiment 3 or 4). For example, the width I may be equal to a few millimeters.

The routing is carried out in such a way that the depth of material h that is removed therefrom is greater than or equal to the depth of implantation e subsequently carried out (as illustrated in figure 3C). The routing depth h may thus be chosen to range between about 1000 Å and several hundred µm. The thickness of this step must be greater than the thickness removed (typically from 1000 to 2000 Å), in order typically to correspond to one or more thicknesses of lifted-off film and of material removed during the reclaiming operation (a few µm), within, of course, the limits set by the thickness of the wafer (several hundred µm).

Thus, if the wafer 30 is essentially circular, the hollow volume obtained after the routing is then an annular cylinder with an outside diameter equal to the diameter of the wafer 30, an inside diameter extending right up to said vertical wall 31a and a height equal to h.

The techniques employed for this routing are substantially the same as those described in document US 20004/0121557, the content of which is incorporated here for reference. These techniques may especially include mechanical machining or chemical etching of the peripheral zone of the wafer 30.

Referring to figure 3B, a second stage according to the invention consists in forming a protective layer 36 on the step 31 (and in particular on the horizontal wall 31b of said step and also on the wall 31a) with a material thick enough to protect the subjacent portion 38 on the implantation subsequently carried out (as illustrated in figure 3C). A protective layer may also be provided on the vertical wall 31 b in order to protect it from exposure to an ion beam that is not perfectly parallel to this wall 31a. Such an "inclined" implantation operation is sometimes also carried out when the crystalline material is implanted without an amorphous protective layer, so as to prevent the phenomenon of channeling.

This protective layer 36 may be produced from any type of material capable of fulfilling this function. Thus, a material in an amorphous phase may be chosen, such as silicon oxide (SiO₂), silicon nitride (Si₃N₄), PSG (phosphosilicate glass) or BPSG (borophosphosilicate glass). The thickness of the protective layer is therefore matched to the material chosen, so as to exhibit sufficient stopping power to the implanted ions.

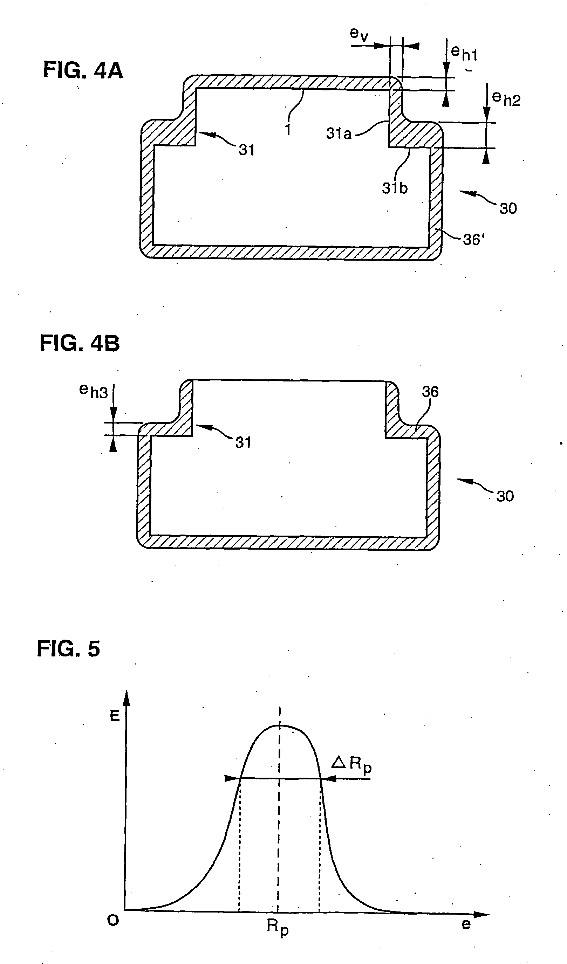

A general method for producing this protective layer is illustrated by figures 4A and 4B and comprises the following stages:
- formation of a layer 36' made of protective material on the wafer 30 (figure 4A); and
- optional removal of those portions of the layer 36' which are not located on the step 31, so as to keep thereon only a protective layer 36 of thickness eₕ₃ on the step 31 (figure 4B).

Referring to figure 4A, the first stage consists in forming a layer 36' of protective material on the wafer 30, the layer 36' having a mean thickness eₕ₁ on the front face 1 of the wafer 30, a mean thickness eₕ₂ on the horizontal wall 31b of the step 31 and a mean thickness eᵥ on the vertical wall 31 a of the step 31.

These layers may be formed by material deposition and/or thermal oxidation methods.

The techniques employed for depositing the layer 36' may be of the LPCVD (Low-Pressure Chemical Vapor Deposition), PECVD (Plasma-Enhanced Chemical Vapor Deposition) or other techniques of the CVD (Chemical Vapor Deposition) type.

When the layer 36' is made of SiO₂, it can be deposited by SiO₂ deposition or it can be formed by means of tetraethoxysilane (TEOS), optionally combined with oxygen and/or ozone, applied to a surface containing silicon, or using silane and O₂ (also called HTO), in LPCVD or in PECVD.

Optionally, dopants may be added to the SiO₂ layer 36', such as phosphorus, and therefore forming a PSG layer 36', or boron and phosphorus, and therefore forming a BPSG layer 36'.

When the protective layer 36' is made of Si₃N₄ or SiₓN_{y}H_{z}, it may be deposited using SiCl₂H₂ and NH₃ (in LPCVD) or SiH₄ and NH₃ (in PECVD).

Using LPCVD techniques typically results in the formation of a layer 36' having a substantially constant thickness (i.e. eₕ₁, eₕ₂ and eᵥ are approximately equal) over the entire exposed surfaces. Thus, the layer will be formed substantially uniformly on the front face 1, the rear face 2 and on the step 31 of the wafer 30.

Using PECVD techniques typically results in the formation of a layer 36' that does not have a substantially constant thickness, the deposition mainly taking place on the faces directly exposed (the front face 1, the rear face 2 and the horizontal wall 31 b of the step 31) and to a lesser extent on the sidewall (the vertical wall 31 a of the step 31).

When the layer 36' is formed by thermal oxidation of the exposed surfaces of the wafer 30, these must therefore include silicon or another easily oxidizable material. Oxidation may lead to the formation of a layer 36' that has different oxidized thicknesses on the front face 1, the rear face 2 and on the sidewall, the oxidation rates being dependent on the orientation of the crystal lattice on the surfaces to be oxidized.

The layer 36' may finally include a coating of resin or polymer, or it may be completely formed therefrom.

Thus, the entire layer 36' may be formed by thermal oxidation, by material deposition or by oxidation followed by material deposition. In the last case, thin oxidation prior to deposition may in fact be envisaged for the purpose of improving the quality of the interface with the wafer 30, it then being possible to form a passivation layer, or for the purpose of limiting any contamination caused by the subsequent deposition, or for the purpose of forming a stop layer during removal by selective etching of the deposited layer.

In any case, to fulfill its protection role, the thickness of the protective layer 36 on the step 31, finally formed from the formation of the layer 36', must be greater than the maximum penetration of the ions into the material for the energy and dose intended. It may be considered that a protective layer 36 with a thickness of Rₚ + 5ΔRₚ or greater, (Rₚ being the depth associated with the peak of the Gaussian distribution of the implant and ΔRₚ being the standard deviation of this distribution - see figure 5 as illustration) is sufficient to fulfill its protection function. This is because the Applicant has estimated that such a thickness is sufficient for the formation of a protective layer 36 that is sufficiently protecting.

It is possible to minimize the material to be deposited, and therefore the cost of the operation, by thus adjusting the thickness of the layer 36'.

Optionally, a removal step may be provided, for removing those portions of the layer 36' present on the front face 1, and not located on the step 31, so as to keep only a protective layer 36 of thickness eₕ₃ on the step 31, as illustrated in figure 4B.

Thus, the film that will be taken off (on the front face 1) is exposed and the step 31 is protected from the subsequent implantation.

For this purpose, and using a first technique, the front face 1 of the wafer 30 may be etched, either isotropically or anisotropically. For example, a plasma RIE (Reactive Ion Etching) anisotropic etching technique may be used, this being a preferred technique. Anisotropic etching is particularly suitable in the case in which the layer 36' is deposited uniformly with a thickness eₕ₁ > I (for example by means of an LPCVD technique). Since the width I of the step is of the order of 1 mm (typically between 0.5 mm and 3 mm), it is therefore preferable for eₕ₁ to be substantially larger than the maximum depth of penetration of the ions into the material. The subsequent removal of a thickness typically of between eₕ₁ and 1.3eₕ₁ (a safety margin) means that the protective layer 36 on the step 31 is preserved.

The techniques employed for removing those portions of the layer 36' not located on the step 31 may also include, at least in part, selective polishing, such as polishing in which SiO₂ is removed more rapidly than a subjacent silicon surface, on the front face 1 and optionally on the rear face 2.

Alternatively, techniques for forming the protective layer 36 that do not require the removal of material may also be employed. Thus, for example, if the nature of the materials involved so allows, simple oxidation of the wafer 30 may allow the step 31 to be selectively oxidized without oxidizing the front face 1 (of the film to be taken off). This is the case for example when the wafer 30 consists of a hybrid substrate formed from a Ge layer (which does not oxidize, or the oxide of which is not stable) on an Si substrate (which itself oxidizes), the step 31 being made of Si and the front face 1 made of Ge.

### Example 1: formation of the protective layer 36:

- LPCVD deposition of a thin SiO₂ layer;
- anisotropic etching, such as RIE etching, in order to remove the protective material present on the front face 1.

### Example 2: formation of the protective layer 36:

- PECVD deposition of SiO₂ or Si₃N₄, optionally preceded by a thin thermal oxidation; a thickness of Rₚ + 5*ΔRₚ (see above) or greater may be chosen. Thus, by adjusting the thickness of the layer 36' it is possible to minimize the amount of material to be deposited, and therefore the cost of the operation; and
- CMP (Chemical-Mechanical Planarization) polishing on at least the front face 1 in order to remove the SiO₂ or -Si₃N₄ layer selectively over the subjacent material.

### Example 3: formation of the protective layer 36:

- thermal oxidation of the wafer 30; and
- CMP polishing on at least the front face 1 in order to remove the SiO₂ and Si₃N₄ layer selectively over the subjacent material.

### Example 4: formation of the protective layer 36:

- preferential formation of at least a thin Si₃N₄ or SiO₂+Si₃N₄ layer of between about 5 and about 50 nanometers in thickness, so as to protect the wafer 30 from the contaminants that accompany PSG or BPSG formation;
- deposition of PSG or BPSG;
- thermal annealing between about 850°C and about 1100°C, so as to make the PSG or BPSG flow. The effective thickness eₕ₃ on the step 31 therefore increases, and then depends on thicknesses eₕ₂ and eᵥ, initially formed on the step, on the thickness eₕ₁ of the material on the front face 1, on the annealing temperature and on the concentration of P and optionally the concentration of B; and
- CMP polishing on at least the front face 1 in order to remove the SiO₂ or Si₃N₄ layer selectively over the subjacent material.

In all cases, the steps of forming and of removing the layer 36' are carried out in such a way that the thickness eₕ₃ of the remaining protective layer 36 on the step 31 is straight enough, for the material in question, to protect the subjacent peripheral zone 38 of the wafer 30 from being implanted with atomic species of the type used for preparing for a film taking-off.

Thus, for implantation energies of between 20 keV and 210 keV and an atomic species (hydrogen and/or helium) dose of between 1 x 10¹⁶ at/cm² and 1 x 10¹⁷ at/cm², an SiO₂ protective layer 36 with a thickness eₕ₃ of greater than about 2 microns may provide sufficient protection.

Finally, referring to figure 3B, the wafer 30 includes a front portion 310 having the step 31 and a rear portion 320 corresponding to the part that was not routed. The peripheral portion 38 of the rear portion 320 is determined as the part lying beyond the horizontal wall 31a of the step 31.

This peripheral portion 38 of the wafer 30 is therefore protected by the protective layer 36 from any implantation of atomic species through the front face 1 of the wafer 30. Thus, the lower portion 320 of the wafer 30 is preserved from any weakening due to the ion implantation, unlike in the conventional techniques.

Referring to figure 3C, an atom implantation step is carried out through the front face 1 of the wafer 30 so as to create an implanted zone 32 at a depth e, advantageously determined as being less than or equal to the height h of the step 31.

The atomic species employed may be helium and/or hydrogen and/or other types of ionized atomic species, having a dose of between 1 x 10¹⁶ at/cm² and about 1 x 10¹⁷ at/cm².

The implantation energy is typically between 20 keV and 210 keV.

Optionally, an operation to remove (preferably selectively) the protective layer 36 is carried out. It is preferable to remove this by etching, as a mechanical removal operation could lead to particulate contamination prejudicial to the quality of the bonding and of the structure to be formed. For example, HF may be used for selectively etching an SiO₂ protective layer 36.

The film 35 to be taken off is then bounded by the implanted zone 32 and by the front face 1 of the wafer 30.

The implanted zone 32 thus constitutes a zone of weakness within which the bonds between the film 35 and the subjacent portion of the wafer 30 are weaker than elsewhere.

Figure 3D shows a stage in which a receiving substrate 40 is bonded to the wafer 30 on its front face 1.

It is advantageous to prepare one or both surfaces to be bonded prior to the bonding operation so as to make these surfaces more hydrophilic and of better quality for the bonding. For example, it will be possible to carry out RCA cleaning, or plasma activation, or chemical cleaning based on hydrochloric acid, chemical-mechanical planarization, polishing, etc.

Optionally, and before the implantation, a bonding layer is formed on one or both surfaces to be bonded so as to improve the quality of the bonding. Optionally, this bonding layer or these bonding layers are made of insulating material so that the film 35 once taken off is electrically isolated from the receiving substrate 40. An SiO₂ or Si₃N₄ bonding layer may thus be used.

As a variant, the bonding layer on the wafer 30 may have been formed during the protective layer 36, by leaving at least one portion of the protective material 36' deposited on the front face 1 of the wafer 30 (see figure 4A).

A heat treatment suitable for increasing the bond strength may optionally be carried out after the bonding, for example at a temperature of between about 200°C and about 350°C for a few hours.

The receiving substrate 40, in a first embodiment, has a bonding surface whose area is greater than that of the front face 1 of the wafer 30. The film 35 to be taken off then has an area less than the receiving substrate 40 onto which it will be transferred.

In a second embodiment, the receiving substrate 40 has a bonding surface whose area is substantially identical to that of the front face 1 of the wafer 30 so that the combination of the receiving substrate 40 and the film 35 to be taken off has no visible peripheral step. For this purpose, it is possible in particular to carry out a suitable routing operation on the receiving substrate 40 prior to bonding, or to choose a starting wafer 30 that is slightly larger than the receiving substrate 40 and to carry out the suitable routing in such a way that in the end the front face 1 has an area substantially identical to that of the receiving substrate 40. This second embodiment may be preferred, as it makes it possible to eliminate or minimize any exclusion zone (nontransferred zone) on the final product relative to the free space caused by the routing, which exclusion zone would be generated if the wafer 30 after routing had had a different size from that of the receiving substrate 40.

A supply of energy, such as thermal and/or mechanical energy, then allows the bonds in the implanted zone 32 to be broken and thus enables the film 35 to be transferred from the wafer 30 onto the receiving substrate 40, and therefore to produce the structure 50 shown in figure 3E.

If the lifted-off film 35 is made of semiconductor material and if a bonding layer made of insulating material was provided between the wafer 30 and the receiving substrate 40, the structure 50 obtained is then a semiconductor-on-insulator structure.

An optional finishing stage may then be provided, in order to eliminate any roughness from the detached surface of the film 35 and to make this surface one of high quality.

Referring to figure 3F, the wafer 30' after taking-off comprises a front portion 310' amputated from the film 35 and a rear portion 320 entirely preserved thanks to the presence of the protective layer 36 on the step 31.

The protective layer 36 may possibly then be removed, if this has not already been done, for example by etching, optionally selective etching.

This wafer 30' may then be optionally reclaimed, so as to be used once again as donor wafer for a new film taking-off.

For this purpose, the front face 1' is advantageously treated so as to become a bonding surface of sufficient quality to ensure good bonding to another receiving substrate.

If this treatment involves the use of chemical species, the protective layer 36 may serve to protect the rear portion 320 of the wafer 30, and in particular the step 31 (vertical wall 31 a and horizontal wall 31 b), from any chemical attack. The material of the protective layer 36 may thus be chosen for this purpose. Care should therefore be taken to produce the protective layer 36, if this has not already been done, before the etching.

The front portion 310' of the wafer 30 can then be thickened by means of an epitaxial growth on its front face 1' treated so as to receive the newly implanted atomic species for the purpose of a subsequent film taking-off. This epitaxy may optionally be preceded by a polishing or etching step.

It is therefore preferable to have chosen a protective layer 36 made of an amorphous material so that the epitaxy takes place only on the front face 1' of the wafer 30', and not also on the step 31. Thus, in this case, the protective layer 36 also fulfills the function of protecting the step 31 from any deposition.

In a first embodiment, the implantation for preparing the next taking-off is carried out directly after the treatment of the front face 1' if a protective layer 36 has already been formed, or, if this is not so, directly after the formation of the protective layer 36.

In a first particular case, the new implantation is located at a depth greater than the height h' of the step 31. Thus, after taking-off, a ring in accordance with what is known from the prior art (see in particular figure 1 C) is again obtained, with the exception that the rear portion 320 of the wafer 30 in this case remained intact.

In another particular case, the implant depth is less than the height h' of the step 31 and the taking-off is then substantially in accordance with the taking-off according to the invention with reference to figures 3B to 3F. In this particular case, provision will thus be made to route down to a depth such that there is a means of lifting off two films from the front part 310 of the wafer 30, without encroaching on the rear portion 320 of the wafer 30.

In a second embodiment, a further routing operation is carried out so as to increase the height h' of the step so that the next atom implantation takes place at a depth of less than or equal to the next height of the step 31. The method of preparing the wafer 30 for taking-off described above with reference to figures 3A to 3F then applies in the rest of the process for this last taking-off.

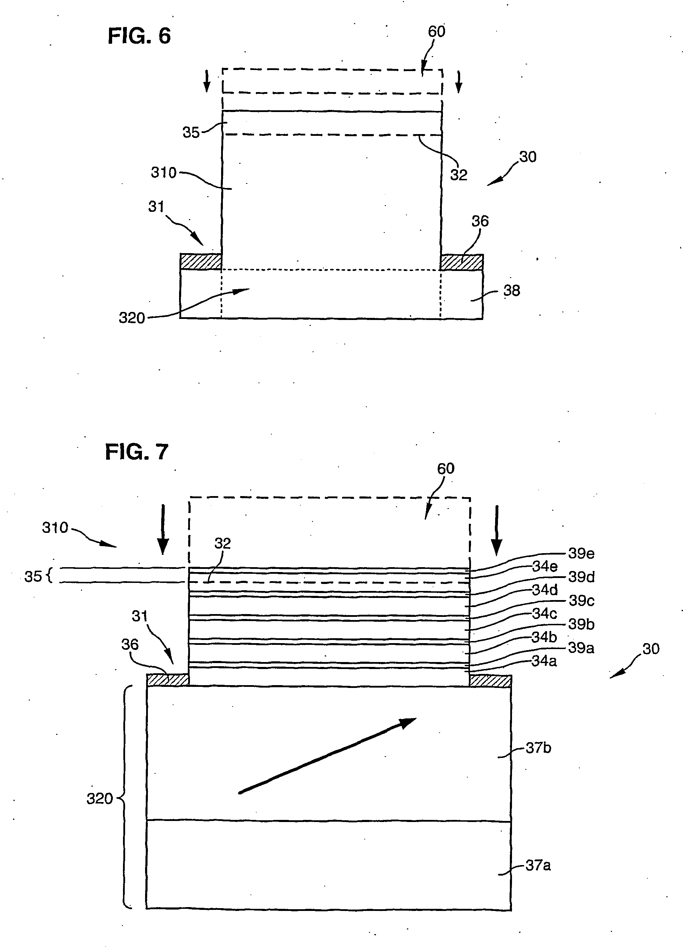

Figures 6 and 7 show particular cases of films being successively taken off from the same wafer 30, which has a peripheral step 31 protected according to the invention.

Referring to figure 6, the height of the step 31 in this wafer 30 is such that the front portion 310 of the wafer 30 is sufficiently thick to successively take off one or more films therefrom, without having to route between each taking-off.

In a first embodiment of this step 31, a routing operation is carried out according to what was mentioned above, down to a suitable depth and over a suitable width.

The detachment face of the wafer 30 is simply reclaimed between each taking-off.

This structure is particularly efficient, as it offers the possibility of several successive films being rapidly and simply taken off, while still preserving the donor wafer 30.

Furthermore, the protective layer 6 guarantees protection of the rear portion 320 of the wafer 30, and in particular protects the subjacent portion 38 from successive atom implantations to which it would be subjected otherwise. Thus, if this protective layer 36 were not present, the subjacent portion 38 would become increasingly fragile as films are progressively taken off, to the point where particles would be detached and contaminate the front portion 310, the lifted-off film 50 and the receiving substrate 40.

Thus, for example the rear portion 320 of the wafer 30 may consist of a silicon support substrate followed by a buffer structure made of SiGe having a germanium concentration that progressively increases over the thickness until reaching a concentration x (of between 0 and 1) on a determined surface. The front portion 310 may in this case for example be made of an epitaxially grown Si₁₋ₓGeₓ material, the concentration x of which is substantially identical to that of the material constituting the surface of the subjacent buffer layer.

In a second embodiment of the step 31 of figure 6, the front portion 310 has been bonded to the rear portion 320, this front portion 310 having a smaller area than the rear portion 320 so that, after bonding, said step 31 appears without it being absolutely necessary to carry out an additional routing operation. The height of this pre-existing step 31 is then about half the height of the transferred film (1700 A for example, with about 200 A of crystalline layer and about 1500 A of bonding layer). The front portion 310 may thus be taken off an initial donor wafer using a film transfer technique, for example Smart-Cut^{®}.

Again in this second embodiment of the step 31, the bonding stage may include the formation of a bonding layer made of insulating material on one or both of the surfaces to be bonded. The wafer 30 produced is then of the semiconductor-on-insulator type, such as a wafer 30 of the SiGeOI type (for example by bonding a front portion 310 made of relaxed SiGe), referring for example to the technique described in FR 02/08600 incorporated here for reference. In particular, this wafer 30 may be produced by oxide/oxide bonding, that is to say an oxide bonding layer, for example about 1500 A in thickness, will have been formed on the front portion 310 (the relaxed SiGe layer) and an oxide bonding layer, for example about 1500 A in thickness, will have been formed on the rear portion 320 (for example made of bulk Si).

The bonding layer formed on the rear portion 320 may also act as a protective layer 36 on the horizontal face 31 a of the step 31.

After optional heat treatments, with a view to improving the crystalline quality of the transferred film, this front portion 310 may be thickened up to about 2 microns. After this deposition, a wafer 30 as shown in figure 6 is therefore obtained (without having carried out a specific routing operation).

Optionally, routing may then be carried out, over a lateral distance (for example of between about 1 mm and about 3 mm) so as to produce a sharp contour on the step 31. A protective layer 36 according to the invention is then formed.

Figure 7 illustrates a wafer 30 that has been routed over a height such that the front portion 310 can provide several films by taking-off according to the invention, without it being necessary to route it between each taking-off.

The front portion 310 is a composite structure comprising alternately layers of a first material (34a, 34b, 34c, 34d, 34e) and layers of a second material 39a, 39b, 39c, 39d, 39e), these being initially formed by epitaxy starting from the rear portion 320 of the wafer and before routing. Thus, it will be possible to have a front portion 310 consisting of a succession of SiGe layers (34a, 34b, 34c, 34d, 34e) and a succession of elastically strained material Si_{1-y}Ge_{y} layers (39a, 39b, 39c, 39d, 39e), where x differs from y, and x and y are between 0 and 1 respectively, these layers being grown epitaxially from the rear portion 320, including an SiGe buffer layer 37b and a bulk Si support substrate 37a.

One of the successive implantations for preparing for successive taking-offs may therefore be carried out within an Si₁₋ₓGeₓ layer (34e) so as to therefore prepare the transfer, with the subjacent strained Si_{1-y}Ge_{y} layer (39e), onto the receiving substrate 40.

It will therefore be possible to treat the structure comprising the receiving substrate and these lifted-off films so as to preserve only a portion of the Si₁₋ₓGeₓ layer, so as to obtain a strained Si₁₋ₓGeₓ/Si_{1-y}Ge_{y}-on-insulator structure.

As an alternative, the entire Si₁₋ₓGeₓ remainder is removed so as in the end to obtain a strained Si_{1-y}Ge_{y}-on-insulator structure. For this purpose, selective etching between these two materials may be carried out.

As regards the remaining wafer 30, the taking-off surface may be reclaimed so as to preserve at least a portion of the layer 34e into which the atomic species were implanted, by means of a polishing or chemical etching operation.

As an alternative, the entire remainder of the layer 34e is removed by carrying out selective etching between Si₁₋ₓGEₓ and the subjacent Si_{1-y}Ge_{y} (layer 39d).

It should be noted that the protective layer 36 may also protect the rear portion 320 of the plate 30, and in particular the step 31 (vertical wall 31a and horizontal wall 31b), from such chemical attack. A material suitable for producing such a stop layer may in particular be chosen.

In one particular case according to the proposed method illustrated in figure 7, y is chosen to be equal to 0 so that the strained Si_{1-y}Ge_{y} layers (layers 39a, 39b, 39c, 39d, 39e) are made of elastically strained Si.

More generally, the invention is not limited to just the examples mentioned above - in particular, the wafer 30 is not necessarily protected by a protective layer 36 formed on the step 31 - but extends to any type of protection capable of protecting the step 31 from implantation.

Thus, in a first alternative method of protection, a mask may be provided on the step 31 during implantation. This mask may thus be designed so as to permit only the passage of ions intended to form the zone of weakness 32 beneath the front face 1 of the wafer 30 and to prevent ions from reaching the step 31. This mask may be located level with the implanter or level with the wafer 30, or at an intermediate level.

In a second alternative method of protecting the step 31, and within the context in which an implantation system allowing an ion beam to scan one or more wafers 30 along a predetermined path is used, this predetermined path is determined so that the ions reach only the front face 1 of each wafer 30 and do not reach the step 31. Suitable means for controlling the ion beam and/or the moving support for the wafer(s) 30 may thus predefine the path of the ions on each wafer 30. Thus, the scanning may be automatically controlled, for example by predetermining the path using an automation computer program.

Of course, a person skilled in the art will thus understand that this invention is not limited to the case of SiGe and strained Si, but may be applied to any crystalline or noncrystalline material, in which a taking-off or an atom implantation according to the invention may be carried out. In particular, crystalline materials may be chosen that belong to the family of II.VI or III.V alloys and/or doped materials and/or materials that include carbon with a concentration ranging from about 5% to about 50%.

## Claims

1. A method of producing a film (35) intended for applications in electronics, optics or optronics starting from an initial wafer, which comprises the following stages:
(a) formation of a step (31) of determined height (h) around the periphery of the wafer, the mean thickness of the wafer at the step being less than the mean thickness of the rest of the wafer;
(c) implantation of atomic species through one of the faces of said initial wafer, so as to form an implanted zone (32) at a determined implant depth; the method being **characterized in that**, between stages a) and c), it comprises a stage (b) of forming on said step (31), a protective layer (36) against implantation of atomic species from the face of the wafer having said step, the thickness of said protective layer (36) being greater than the maximum penetration of the ions into the material of said protective layer (36) for the energy and dose used in stage (c) and **in that** the implantation of stage c) is done through that face of the wafer having said step (31), said film (35) being determined, on one side, by the implanted face of the wafer and, on the other side, by the implanted zone (32).

2. The film production method as claimed in the preceding claim, wherein stage (a) includes the bonding of a film to a substrate in order to form said initial wafer, the film having a smaller area than the substrate so that, once these have been bonded, said step is at least partly determined by the difference in area between the film and the substrate.

3. The film production method as claimed in either of the preceding claims, wherein stage (a) includes the removal of material from a peripheral surface of the wafer down to a determined removal depth so as to form said step.

4. The film production method as claimed in one of the preceding claims, wherein stage (a) furthermore includes a thickening of the step.

5. The film production method as claimed in one of the preceding claims, wherein the implant depth is equal to the height of the step or less.

6. The film production method as claimed in one of the preceding claims, wherein the wafer has previously been subjected to a film taking-off operation, the wafer therefore having a ring on a peripheral zone, wherein stage (a) includes the prior removal of this ring.

7. The film production method as claimed in one of the preceding claims, wherein the height of the step is chosen as being about 1 micron or more.

8. The film production method as claimed in any one of the preceding claims, wherein the protective layer is formed during stage (b) on portions of the wafer that are not located on the step.

9. The film production method as claimed in any one of the preceding claims, wherein stage (b) is implemented in such a way that the thickness of the protective layer formed is on average substantially equal to or greater than the sum of said implantation depth, which is that associated with the peak of the Gaussian distribution of the implantation, and of a depth corresponding to about five times the standard deviation of this distribution.

10. The film production method as claimed in any one of the preceding claims, wherein the protective layer is formed during stage b) on portions of the wafer that are not located on the step (31) and which further includes an operation to remove those portions of the protective layer which are not located on the step.

11. The film production method as claimed in the preceding claim, wherein this removal stage is implemented by anisotropic etching.

12. The film production method as claimed in claim 10, in which said removal is carried out by polishing the wafer.

13. The film production method as claimed in any one of the preceding claims, which further includes a step of removing the protective layer after stage (c).

14. The film production method as claimed in one of the preceding claims, wherein stage (b) is implemented in such a way that the protective layer is a layer made of amorphous material.

15. The film production method as claimed in the preceding claim, wherein the protective layer comprises silicon oxide, silicon nitride, PSG or BPSG.

16. The film production method as claimed in one of the preceding claims, wherein stage (c) is implemented in such a way that the implanted zone is a zone of weakness, wherein the method furthermore includes the following stages:
- a receiving substrate is bonded to the implanted face of the wafer; and then
- energy is supplied so as to detach the film from the wafer in the zone of weakness.

17. The film production method as claimed in claim 16, wherein the receiving substrate has also undergone, prior to bonding, material taking-off similar to that in stage (a), so as to have a bonding surface substantially identical to that of the wafer.

18. The film production method as claimed in either of claims 16 and 17, wherein, after detachment, stages (b) to (c) are again carried out.

19. The film production method as claimed in either of claims 16 and 17, wherein said initial step height and said implant depth are chosen in such a way that, after detachment of the film, there is a means of forming a second film by implantation of atomic species through the detachment surface at a second implant depth less than or equal to the mean height of the step.

20. The film production method as claimed in either of claims 16 and 17, which further includes, one or more times, the following successive stages:
- implantation of atomic species through the surface on which the previous film was detached, so as to form a zone of weakness defining a new layer beneath the detachment surface;
- a receiving substrate is bonded to the implanted face of the wafer; and then
- energy is supplied so as to detach the film from the wafer in the zone of weakness.

21. The film production method as claimed in the preceding claim, wherein said initial step height and the depths of successive implantations are chosen in such a way that, after detachment from the last of the successively detached films, the mean thickness of the wafer taken level with said step is equal to or less than the mean thickness of the wafer taken level with the last detachment surface.

22. The film production method as claimed in claim 21, wherein said initial step height and the depths of successive implantations are chosen in such a way that, after detachment of the last of the successively detached films, there is a means of forming another layer by implantation of atomic species through the detachment surface at a depth less than or equal to the mean height of the step.

23. The film production method as claimed in one of claims 20 to 22, wherein a cleaning and/or chemical etching operation is carried out after detachment of a film, in such a way that the quality of the detachment surface is sufficient to carry out a further bonding operation to a receiving substrate for a further film taking-off from the wafer.

24. The film production method as claimed in the preceding claim, wherein the protective layer formed in stage b) is also capable of protecting the step from the chemical agents used during the cleaning and/or chemical etching operation.

25. The film production method as claimed in the preceding claim, wherein, after the protective layer has been formed, an epitaxial layer is grown on the front face (1') of the wafer, prior to the next implantation step.

26. The film production method as claimed in one of claims 16 to 25, wherein the wafer comprises an Si₁₋ₓGeₓ layer on a substrate, x being between 0 and 1, each film being taken off from this Si₁₋ₓGeₓ layer.

27. The film production method as claimed in one of claims 16 to 25, wherein the wafer comprises an Si₁₋ₓGeₓ layer and then an elastically strained Si_{1-y}Ge_{y} layer on a substrate, x and y being between 0 and 1, y being substantially different from x, and the implantation taking place in the Si₁₋ₓGeₓ layer.

28. The film production method as claimed in one of claims 20 to 25, wherein the wafer comprises a composite structure on a support substrate, the composite structure being formed from an alternation of Si₁₋ₓGeₓ layers and elastically strained Si_{1-y}Ge_{y} layers, x and y being between 0 and 1, y being substantially different from x, and each implantation taking place in an Si₁₋ₓGeₓ layer.

29. The film production method as claimed in the preceding claim, wherein at least one selective etching operation is carried out after taking-off, so as to at least remove the remainder of the Si₁₋ₓGeₓ layer.

30. A wafer (30) for providing a film (35) intended for applications in electronics, optics or optronics, which comprises a front face (1) and a rear face (2) and which includes a peripheral zone having a mean thickness smaller than the rest of the wafer, so as to form a front portion (310) having a step (31) around the periphery of the wafer and a rear portion (320) not routed, said step (31) comprising a vertical wall (31 a) lying essentially perpendicular to said front face (1) and a horizontal wall (31 b) lying parallel to said front face (1), these two walls (31a, 31 b) intersecting each other, the height (h) of said step (31) being about 1 micrometers or more, said wafer (30) comprising a buried implanted zone (32) located inside the front portion (310) at a depth(e) from the front face (1) less than or equal to the height(h) of the step (31), said film (35) extending between said front face (1) and said burried implanted zone (32), **characterized in that** the step (31) is coated with a protective layer (36) against implantation with atomic species from the front face (1), the thickness of said protective layer (36) being greater that the one of said film (35).

31. The wafer as claimed in the preceding claim, wherein the protective layer (31) is made of amorphous material.

32. The wafer as claimed in either of the two preceding claims, wherein the protective layer (31) comprises silicon oxide, silicon nitride, PSG or BPSG.

33. The wafer as claimed in one of claims 30 to 32, wherein the wafer is made of bulk crystalline material.

34. The wafer as claimed in one of claims 30 to 32, wherein the wafer is a composite structure consisting mainly of crystalline materials.

35. The wafer as claimed in the preceding claim, wherein the wafer comprises a support substrate, a buffer structure and an upper layer sufficiently thick to be able to detach therefrom a film by Smart-Cut^{®}.

36. The wafer as claimed in the preceding claim, wherein the upper layer comprises Si₁₋ₓGeₓ.

37. The wafer as claimed in the preceding claim, wherein the upper layer optionally comprises Si₁₋ₓGeₓ and Si_{1-y}Ge_{y}, with x differing from y, x and y being between 0 and 1, respectively.

38. The wafer as claimed in one of the claims 35 to 37, wherein the height of the step (31) is equal to or greater than the thickness of the upper layer.

## Patentansprüche

1. Verfahren zur Herstellung einer Schicht (35) für den Gebrauch in Anwendungen der Elektronik, Optik oder Optronik, ausgehend von einem ursprünglichen Wafer, das die folgenden Schritte umfasst:
(a) Bildung eine Stufe (31) mit bestimmter Höhe (h) um die Peripherie des Wafers herum, wobei die mittlere Dicke des Wafers bei der Stufe weniger beträgt als die mittlere Dicke des Restes des Wafers;
(c) Implantation einer atomaren Spezies durch eine der Oberfläche des ursprünglichen Wafers, um eine Implantierzone (32) mit einer bestimmten Implantiertiefe zu bilden;
wobei das Verfahren **dadurch gekennzeichnet ist, dass** zwischen den Schritten a) und c) es einen Schritt (b) des Bildens einer Schutzschicht (36) auf der Stufe (31) gegen die Implantation der atomaren Spezies von der Oberfläche des Wafers mit der Stufe her umfasst, wobei die Dicke der Schutzschicht (36) größer ist als die maximale Penetration der Ionen in das Material der Schutzschicht (36), bezogen auf die Energie und Dosis, die in Schritt (c) verwendet wird, und dass die Implantation des Schrittes c) durch die Oberfläche des Wafers mit der Stufe (31) erfolgt, wobei die Schicht (35) auf der einen Seite durch die implantierte Oberfläche des Wafers und auf der andern Seite durch die implantierte Zone (32) bestimmt ist.

2. Verfahren zur Herstellung einer Schicht gemäß dem vorangehenden Anspruch, wobei Schritt (a) das Bonden einer Schicht auf einem Substrat zum Formen des ursprünglichen Wafers mit einschließt, wobei die Schicht eine kleinere Oberfläche als das Substrat aufweist, derart, dass die Stufe nach dem Bonden wenigstens teilweise durch den Unterschied in der Fläche zwischen der Schicht und dem Substrat bestimmt ist.

3. Verfahren zur Herstellung einer Schicht gemäß einem der vorangehenden Ansprüche, wobei Schritt (a) das Entfernen von Material von einer peripheren Oberfläche des Wafers bis hinunter zu einer bestimmten Entfernungstiefe derart mit einschließt, das die Stufe gebildet wird.

4. Verfahren zur Herstellung einer Schicht gemäß einem der vorangehenden Ansprüche, wobei Schritt (a) weiterhin eine Verdickung der Stufe mit einschließt.

5. Verfahren zur Herstellung einer Schicht gemäß einem der vorangehenden Ansprüche, wobei die Implantiertiefe gleich oder weniger beträgt als die Höhe der Stufe.

6. Verfahren zur Herstellung einer Schicht gemäß einem der vorangehenden Ansprüche, wobei der Wafer vorher einer Schichtentfernungsmaßnahme unterzogen wurde, und der Wafer hierfür einen Ring auf einer peripheren Zone aufweist, wobei Schritt (a) das vorherige Entfernen dieses Ringes mit einschließt.

7. Verfahren zur Herstellung einer Schicht gemäß einem der vorangehenden Ansprüche, wobei die Höhe der Stufe als etwa 1 Mikron oder mehr gewählt wird.

8. Verfahren zur Herstellung einer Schicht gemäß einem der vorangehenden Ansprüche, wobei die Schutzschicht in Schritt (b) auf Teilen des Wafers, die nicht auf der Stufe gelegen sind, gebildet wird.

9. Verfahren zur Herstellung einer Schicht gemäß einem der vorangehenden Ansprüche, wobei Schritt (b) derart implementiert ist, dass die Dicke der gebildeten Schutzschicht im Durchschnitt im wesentlichen gleich oder größer als die Summe der Implantiertiefe ist, was auf das Maximum der Gaussverteilung der Implantation und auf eine Tiefe entsprechend etwa fünf mal der Standardabweichung dieser Verteilung bezogen ist.

10. Verfahren zur Herstellung einer Schicht gemäß einem der vorangehenden Ansprüche, wobei die Schutzschicht in Schritt b) auf Teilen des Wafers, die nicht auf der Stufe (31) gelegen sind, gebildet wird, und das weiterhin eine Maßnahme zur Entfernung dieser Teile der Schutzschicht, die nicht auf der Stufe gelegen sind, mit einschließt.

11. Verfahren zur Herstellung einer Schicht gemäß dem vorangehenden Anspruch, wobei diese Entfernungsmaßnahme als anisotropes Ätzen implementiert ist.

12. Verfahren zur Herstellung einer Schicht gemäß Anspruch 10, wobei das Entfernen durch Polieren des Wafers durchgeführt wird.

13. Verfahren zur Herstellung einer Schicht gemäß einem der vorangehenden Ansprüche, das weiterhin einen Schritt des Entfernens der Schutzschicht nach Schritt (c) umfasst.

14. Verfahren zur Herstellung einer Schicht gemäß einem der vorangehenden Ansprüche, wobei Schritt (b) derart implementiert ist, dass die Schutzschicht eine Schicht aus amorphem Material umfasst.

15. Verfahren zur Herstellung einer Schicht gemäß dem vorangehenden Anspruch, wobei die Schutzschicht Silikonoxid, Silikonnitrit, PSG oder BPSG umfasst.

16. Verfahren zur Herstellung einer Schicht gemäß einem der vorangehenden Ansprüche, wobei Schritt (c) derart implementiert ist, dass die implantierte Zone eine Schwächezone ist, wobei das Verfahren weiterhin die folgenden Schritte mit einschließt:
- ein empfangendes Substrat ist zu der implantierten Oberfläche des Wafers hin gebondet; und dann
- Aufwenden von Energie, um die Schicht in der Schwächezone von dem Wafer abzuziehen.

17. Verfahren zur Herstellung einer Schicht gemäß Anspruch 16, wobei das empfangende Substrat ebenfalls vor den Bonden einer Materialentfernungsmaßnahme unterzogen wurde, ähnlich wie in Schritt (a), um eine Bonding-Oberfläche im wesentlichen identisch zu der des Wafers zu erhalten.

18. Verfahren zur Herstellung einer Schicht gemäß einem der Ansprüche 16 oder 17, wobei nach dem Entfernen die Schritte (b) bis (c) abermals ausgeführt werden.

19. Verfahren zur Herstellung einer Schicht gemäß einem der Ansprüche 16 oder 17, wobei die ursprüngliche Höhe der Stufe und die Implantiertiefe derart gewählt werden, dass nach Entfernen der Schicht ein Mittel zum Bilden einer zweiten Schicht durch Implantation einer atomaren Spezies durch die abgezogene Oberfläche mit einer zweiten Implantiertiefe, die geringer oder gleich der mittleren Höhe der Stufe ist, vorhanden ist.

20. Verfahren zur Herstellung einer Schicht gemäß einem der Ansprüche 16 oder 17, welches weiterhin, einmal oder mehrmals, die folgenden sukzessiven Schritte mit einschließt:
- Implantation einer atomaren Spezies durch die Oberfläche, von welcher die vorherige Schicht entfernt wurde, um eine Schwächezone zu erzeugen, die eine neue Schicht unterhalb der abgezogene Oberfläche definiert;
- ein empfangendes Substrat ist zu der implantierten Oberfläche des Wafers hin gebondet; und dann
- Aufwenden von Energie um die Schicht in der Schwächezone von dem Wafer abzuziehen.

21. Verfahren zur Herstellung einer Schicht gemäß dem vorangehenden Anspruch, wobei die ursprüngliche Stufenhöhe und die Tiefen von nacheinander folgenden Implantationen derart gewählt werden, dass nach Entfernen der letzten der nacheinander entfernten Schichten die mittlere Dicke der durch den Wafer angenommenen Höhe mit der Stufe gleich oder geringer ist als die mittlere Dicke der durch den Wafer angenommenen Höhe mit der letzten Abgezogenen Oberfläche ist.

22. Verfahren zur Herstellung einer Schicht gemäß Anspruch 21, wobei die ursprüngliche Höhe der Stufe und die Tiefen von nacheinander folgenden Implantationen derart gewählt werden, dass nach Entfernen der letzten der nacheinander entfernten Schichten ein Mittel zum bilden einer weiteren Schicht durch Implantation einer atomaren Spezies durch die abgezogene Oberfläche mit einer Tiefe, die geringer oder gleich der mittleren Höhe der Stufe ist, vorhanden ist.

23. Verfahren zur Herstellung einer Schicht gemäß einem der Ansprüche 20 bis 22, wobei eine Säuberungs- und/oder chemische Ätzmaßnahme nach Entfernen der Schicht durchgeführt wird, derart, dass die Qualität der abgezogenen Oberfläche genügend ist, um eine weitere Bonding-Maßnahme auf ein empfangenden Substrat für einen weiteren Schichtabzug von dem Wafer durchzuführen.

24. Verfahren zur Herstellung einer Schicht gemäß dem vorangehenden Anspruch, wobei die in Schritt b) gebildete Schutzschicht auch dazu geeeignet ist, die Stufe vor den chemischen Wirkstoffen, die während der Säuberungs- und/oder chemischen Ätzmaßnahme einesetzt werden, zu schützen.

25. Verfahren zur Herstellung einer Schicht gemäß dem vorangehenden Anspruch, wobei nach Bildung der Schutzschicht vor dem nächsten Implantationsschritt eine epitaxiale Schicht auf der Frontoberfläche (1') des Wafers aufgewachsen wird.

26. Verfahren zur Herstellung einer Schicht gemäß einem der Ansprüche 16 bis 25, wobei der Wafer eine Si₁₋ₓGeₓ-Schicht auf einem Substrat umfasst, und x zwischen 0 und 1 ist, und jedie Schicht von dieser Si₁₋ₓGeₓ-Schicht abgezogen wird.

27. Verfahren zur Herstellung einer Schicht gemäß einem der Ansprüche 16 bis 25, wobei der Wafer eine Si₁₋ₓGeₓ-Schicht und dann eine elastisch gestreckte Si_{1-y}Ge_{y}-Schicht auf einem Substrat umfasst, wobei x und y zwischen 0 und 1 sind, und y im Wesentlichen unterschiedlich von x ist, und die Implantation in der Si₁₋ₓGeₓ-Schicht stattfindet.

28. Verfahren zur Herstellung einer Schicht gemäß einem der Ansprüche 20 bis 25, wobei der Wafer eine Kompositstruktur auf einem Supportsubstrat und die Kompositstruktur aus einer Alternation von Si₁₋ₓGeₓ-Schichten und elastisch gestreckten Si_{1-y}Ge_{y}-Schichten umfasst, wobei x und y zwischen 0 und 1 sind, und y im Wesentlichen unterschiedlich von x ist, und jede der Implantationen in der Si₁₋ₓGeₓ-Schicht stattfindet.

29. Verfahren zur Herstellung einer Schicht gemäß dem vorangehenden Anspruch, wobei wenigstens eine selektive Ätzmaßnahme nach dem Entfernen durchgeführt wird, um wenigstens die Reste der Si₁₋ₓGeₓ-Schicht zu entfernen.

30. Wafer (30) zum bereitstellen einer Schicht (35) für den Gebrauch in Anwendungen der Elektronik , Optik oder Optronik, welcher eine Frontseite (1) und eine Rückseite (2) umfasst, und eine periphere Zone mit einer mittleren Dicke, die geringer als der Rest des Wafers ist, um einen Frontteil (310) mit einer Stufe (31) um die Peripherie des Wafers herum und einen Rückteil (320), der nicht verdrahtet ist, zu bilden, wobei die Stufe (31) eine vertikaler Wand (31 a), die im Wesentlichen senkrecht zu der Frontseite (1) gelegen ist, und eine horizontale Wand (31b), die parallel zu der Frontseite (1) gelegen ist, umfasst, und sich diese beiden Wände (31 a, 31 b) sich einander kreuzen, und die Höhe (h) der Stufe (31) etwa 1 Mikrometer oder mehr beträgt, der Wafer (30) eine begrabene implantierte Zone (32) umfasst, die innerhalb des Frontteils (310) mit einer Tiefe (e) von der Frontseite (1) von weniger oder gleich der Höhe (h) der Stufe (31) ist, gelegen ist, und die Schicht (35) sich zwischen der Frontseite (1) und der begrabenen Implantierzone (32) aus den, **dadurch gekennzeichnet, dass** die Stufe (31) mit einer Schutzschicht (36) gegen Implantation mit einer atomaren Spezies von der Frontseite (1) her bedeckt ist, und die Dicke der Schutzschicht (36) größer ist als die der Schicht (35).

31. Wafer gemäß dem vorangehenden Anspruch, wobei die Schutzschicht (31) aus einem amorphen Material ist.

32. Wafer gemäß einem der zwei vorangehenden Ansprüche, wobei die Schutzschicht (31) Silikonoxid, Silikonnitrit, PSG oder BPSG umfasst.

33. Wafer gemäß einem der Ansprüche 30 bis 32, wobei der Wafer aus kristallinen Grundmaterial hergestellt ist.

34. Wafer gemäß einem der Ansprüche 30 bis 32, wobei der Wafer eine Kompositstruktur ist, die hauptsächlich aus kristallinen Materialien besteht.

35. Wafer gemäß dem vorangehenden Anspruch, wobei der Wafer ein Supportsubstrat, eine Pufferstruktur und eine obere Schicht, die ausreichend dick ist, um hiervon eine Schicht durch Smart-Cut® abzuziehen, umfasst.

36. Der Wafer gemäß dem vorangehenden Anspruch, wobei die obere Schicht Si₁₋ₓGeₓ umfasst.

37. Wafer gemäß dem vorangehenden Anspruch, wobei die obere Schicht optional Si₁₋ₓGeₓ und Si_{1-y}Ge_{y} umfasst, wobei x und y jeweils zwischen 0 und 1 sind, und y im Wesentlichen unterschiedlich von x ist.

38. Wafer gemäß einem der Ansprüche 35 bis 37, wobei die Höhe der Stufe (31) gleich oder größer ist als die Dicke der oberen Schicht.

## Revendications

1. Procédé de réalisation d'une couche (35) destinée à des applications dans l'électronique, l'optique ou l'optronique à partir d'une plaque initiale qui comprend les étapes suivantes :
(a) formation d'une marche (31) d'une hauteur déterminée (h) en périphérie de la plaque, l'épaisseur moyenne de la plaque au niveau de la marche étant moins importante que l'épaisseur moyenne du reste de la plaque ;
(c) implantation d'espèces atomiques à travers l'une des faces de ladite plaque initiale, de façon à former une zone implantée (32) à une profondeur d'implantation déterminée ;
le procédé étant **caractérisé en ce que**, entre les étapes (a) et (c), il comprend une étape (b) de formation, sur ladite marche (31), d'une couche de protection (36) contre l'implantation d'espèces atomiques, depuis la face de la plaque présentant ladite marche, l'épaisseur de ladite couche de protection (36) étant supérieure à la pénétration maximale des ions dans le matériau de ladite couche de protection (36) pour l'énergie et la dose utilisées à l'étape (c) et **en ce que** l'implantation de l'étape (c) est faite à travers la face de la plaque présentant ladite marche (31), ladite couche (35) étant définie d'une part par la face implantée de la plaque, et d'autre part, par la zone implantée (32).

2. Procédé de réalisation de couche selon la revendication précédente, dans lequel l'étape (a) comprend le collage d'une couche à un substrat pour former ladite plaque initiale, la couche ayant une superficie moins importante que le substrat de sorte que, une fois collés, ladite marche soit au moins en partie définie par la différence de superficies entre la couche et le substrat.

3. Procédé de réalisation de couche selon l'une des revendications précédentes, dans lequel l'étape (a) comprend un retrait de matière d'une surface périphérique de la plaque et sur une profondeur de retrait déterminée de sorte à former ladite marche.

4. Procédé de réalisation de couche selon l'une des revendications précédentes, dans lequel l'étape (a) comprend en outre un épaississement de la marche.

5. Procédé de réalisation de couche selon l'une des revendications précédentes, dans lequel la profondeur d'implantation est inférieure ou égale à la hauteur de la marche.

6. Procédé de réalisation de couche selon l'une des revendications précédentes, dans lequel la plaque a préalablement subi un prélèvement de couche, la plaque comprenant alors une couronne sur une zone périphérique, dans lequel l'étape (a) comprend le retrait préalable de cette couronne.

7. Procédé de réalisation de couche selon l'une des revendications précédentes, dans lequel la hauteur de la marche (31) est choisie comme étant d'environ 1 micromètre ou plus.

8. Procédé de réalisation de couche selon l'une des revendications précédentes, dans lequel la couche de protection est formée lors de l'étape (b) sur des parties de la plaque non situées au niveau de la marche.

9. Procédé de réalisation de couche selon l'une des revendications précédentes, dans lequel l'étape (b) est mise en oeuvre de sorte que l'épaisseur de la couche de protection formée est en moyenne sensiblement égale ou supérieure à la somme de ladite profondeur d'implantation, qui est celle associée au pic de la distribution gaussienne de l'implantation, et d'une profondeur correspondant à environ cinq fois l'écart type de cette distribution.

10. Procédé de réalisation de couche selon l'une des revendications précédentes, dans lequel la couche de protection est formée lors de l'étape (b) sur des parties de la plaque non situées au niveau de la marche et qui comprend en outre une étape de retrait de ces parties de la couche de protection non situées au niveau de la marche.

11. Procédé de réalisation de couche selon la revendication précédente, dans lequel cette étape de retrait est mise en oeuvre par gravure anisotropique.

12. Procédé de réalisation de couche selon la revendication 10, dans lequel ledit retrait est effectué par polissage de la plaque.

13. Procédé de réalisation de couche selon l'une des revendications précédentes, **caractérisé en ce qu'**il comprend en outre une étape de retrait de la couche de protection postérieurement à l'étape (c).

14. Procédé de réalisation de couche selon l'une des revendications précédentes, dans lequel l'étape (b) est mise en oeuvre de sorte que la couche de protection soit une couche en matériau amorphe.

15. Procédé de réalisation de couche selon la revendication précédente, dans lequel la couche de protection comprend de l'oxyde de silicium, du nitrure de silicium, du PSG ou du BPSG.

16. Procédé de réalisation de couche selon l'une des revendications précédentes, dans lequel l'étape (c) est mise en oeuvre de sorte que la zone implantée soit une zone de fragilisation, dans lequel le procédé comprend en outre les étapes suivantes :
- collage d'un substrat récepteur avec la face implantée de la plaque ; puis
- apport d'énergie de sorte à détacher la couche, de la plaque, au niveau de la zone de fragilisation.

17. Procédé de réalisation de couche selon la revendication 16, dans lequel le substrat récepteur a également subi, préalablement au collage, un enlèvement de matière similaire à celui selon ladite étape (a), de sorte à avoir une surface de collage sensiblement identique à celle de la plaque.

18. Procédé de réalisation de couche selon l'une des revendications 16 et 17, dans lequel sont à nouveau mises en oeuvre, après détachement, les étapes (b) à (c).

19. Procédé de réalisation de couche selon l'une des revendications 16 et 17, dans lequel lesdites hauteur initiale de la marche et profondeur d'implantation sont choisies de sorte que, après détachement de la couche, il y ait moyen de former une deuxième couche par implantation d'espèces atomiques à travers la surface de détachement à une deuxième profondeur d'implantation inférieure ou égale à la hauteur moyenne de la marche.

20. Procédé de réalisation de couche selon l'une des revendications 16 et 17, **caractérisé en ce qu'**il comprend en outre, une ou plusieurs, fois les étapes successives suivantes :
- implantation d'espèces atomiques à travers la surface de détachement de la précédente couche, de façon à former une zone de fragilisation délimitant une nouvelle couche sous la surface de détachement ;
- collage d'un substrat récepteur avec la face implantée de la plaque ; et ensuite
- apport d'énergie, de façon à détacher la couche, de la plaque, au niveau de la zone de fragilisation.

21. Procédé de réalisation de couche selon la revendication précédente, dans lequel ladite hauteur initiale de la marche et les profondeurs des implantations successives sont choisies de sorte que, après détachement de la dernière des couches successivement détachées, l'épaisseur moyenne de la plaque prise au niveau de ladite marche soit égale ou inférieure à l'épaisseur moyenne de la plaque prise au niveau de la dernière surface de détachement.

22. Procédé de réalisation de couche selon la revendication 21, dans lequel ladite hauteur initiale de la marche et les profondeurs des implantations successives sont choisies de sorte que, après détachement de la dernière des couches successivement détachées, il y ait moyen de former une autre couche par implantation d'espèces atomiques à travers la surface de détachement, à une profondeur inférieure ou égale à la hauteur moyenne de la marche.

23. Procédé de réalisation de couche selon l'une des revendications 20 à 22, dans lequel un nettoyage et/ou une gravure chimique est mis en oeuvre après le détachement d'une couche, de sorte Si₁₋ₓGeₓ que la qualité de la surface de détachement soit suffisante pour réaliser un autre collage avec un substrat récepteur pour un autre prélèvement de couche dans la plaque.

24. Procédé de réalisation de couche selon la revendication précédente, dans lequel la couche de protection est aussi apte à protéger la marche contre les agents chimiques utilisés lors du nettoyage et/ou de la gravure chimique.

25. Procédé de réalisation de couche selon la revendication précédente, dans lequel, après la formation de la couche de protection, une croissance épitaxiale de couche est effectuée sur la face avant (1') de la plaque, avant la prochaine étape d'implantation.

26. Procédé de réalisation de couche selon l'une des revendications 16 à 25, dans lequel la plaque comprend une couche de Si₁₋ₓGeₓ, sur un substrat, x étant compris entre 0 et 1, chaque couche étant prélevée dans cette couche de Si₁₋ₓGeₓ.

27. Procédé de réalisation de couche selon l'une des revendications 16 à 25, dans lequel la plaque comprend une couche de Si₁₋ₓGeₓ puis une couche de Si_{1-y}Ge_{y} élastiquement contraint, sur un substrat, x et y étant compris entre 0 et 1, y étant sensiblement différent de x, l'implantation ayant lieu dans la couche de Si₁₋ₓGeₓ.

28. Procédé de réalisation de couche selon l'une des revendications 20 à 25, dans lequel la plaque comprend une structure composite sur un substrat support, la structure composite étant formée alternativement de couches de Si₁₋ₓGeₓ et de couches de Si_{1-y}Ge_{y} élastiquement contraint, x et y étant compris entre 0 et 1, y étant sensiblement différent de x, chaque implantation ayant lieu dans une couche de Si₁₋ₓGeₓ.

29. Procédé de réalisation de couche selon la revendication précédente, dans lequel au moins une gravure sélective est mise en oeuvre après prélèvement de façon à au moins retirer le reliquat de la couche de Si₁₋ₓGeₓ.

30. Plaque (30) pour fournir une couche (35) destinée à des applications dans l'électronique, l'optique ou l'optronique, qui comprend une face avant (1) et une face arrière (2) et qui inclut une zone périphérique ayant une épaisseur moyenne inférieure au reste de la plaque, de façon à former une portion avant (310) ayant une marche (31) autour de la périphérie de la plaque et une portion arrière (320) non détourée, ladite marche (31) comprenant une paroi verticale (31 a) s'étendant essentiellement perpendiculairement à ladite face avant (1) et une paroi horizontale (31 b) s'étendant parallèlement à ladite face avant (1), ces deux parois (31 a, 31 b) étant sécantes, la hauteur (h) de ladite marche (31) étant d'environ un micromètre ou plus, ladite plaque (30) comprenant une zone implantée enterrée (32), située à l'intérieur de la portion avant (310), à une profondeur (e) prise depuis la face avant (1) inférieure ou égale à la hauteur (h) de ladite marche (31), ladite couche (35) s'étendant entre ladite face avant (1) et ladite zone implantée enterrée (32), **caractérisée en ce que** la marche est recouverte par une couche de protection (36) contre une implantation avec des espèces atomiques depuis la face avant (1), l'épaisseur de ladite couche de protection (36) étant supérieure à celle de la couche (35).

31. Plaque selon la revendication précédente, dans laquelle la couche de protection (36) est en matériau amorphe.

32. Plaque selon l'une des deux revendications précédentes, dans laquelle la couche de protection (36) comprend de l'oxyde de silicium, du nitrure de silicium, du PSG ou du BPSG.

33. Plaque selon l'une des revendications 30 à 32, dans laquelle la plaque est en matériau cristallin massif.

34. Plaque selon l'une des revendications 30 à 32, dans laquelle la plaque est une structure composite constituée principalement de matériaux cristallins.

35. Plaque selon la revendication précédente, dans laquelle la plaque comprend un substrat support, une structure tampon et une couche supérieure suffisamment épaisse pour pouvoir y détacher une couche par Smart-Cut®.

36. Plaque selon la revendication précédente, dans laquelle la couche supérieure comprend du Si₁₋ₓGeₓ.

37. Plaque selon la revendication précédente, dans laquelle la couche supérieure comprend du Si₁₋ₓGeₓ et du Si_{1-y}Ge_{y}, avec x différent de y, x et y étant respectivement compris entre 0 et 1.

38. Plaque selon l'une des revendications 35 à 37, dans laquelle la hauteur de la marche (31) est supérieure ou égale à l'épaisseur de la couche supérieure.
